(19) **Europäisches Patentamt**

**European Patent Office**

**Office européen des brevets**

(11) **EP 1 626 488 A2**

(12) **EUROPÄISCHE PATENTANMELDUNG**

(43) Veröffentlichungstag:
**15.02.2006 Patentblatt 2006/07**

(51) Int Cl.:
**H02M 3/156** (2006.01)   **G01R 19/00** (2006.01)

(21) Anmeldenummer: **05017507.4**

(22) Anmeldetag: **11.08.2005**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(30) Priorität: **13.08.2004 DE 102004039392**

(71) Anmelder: **Peter, Cornelius**
**77815 Bühl (DE)**

(72) Erfinder: **Peter, Cornelius**
**77815 Bühl (DE)**

(74) Vertreter: **Hruschka, Jürgen et al**
**Habermann, Hruschka & Schnabel,**
**Patentanwälte,**
**Montgelasstrasse 2**
**81679 München (DE)**

(54) **Verfahren und Schaltungsanordnung zur Erfassung des Stroms in einem elektrischen Gerät**

(57)     Die Erfindung bezieht sich auf ein Verfahren zur Erfassung des Stroms in einem elektrischen Gerät (1), das über einen mit dem Gerät (1) gekoppelten FET (2) nach dem Pulsweitenmodulationsverfahren angesteuert wird. Bisherige Verfahren, bei denen der Strom über einen Shunt gemessen wurde, waren entweder mit hohen Leistungsverlusten oder aufwendigen Schaltungen verbunden. Gemäß dem Verfahren werden die an der Source-Drain-Strecke des FETs (2) liegende Spannung (Udson) sowie eine Temperatur in der Umgebung des FETs (2) gemessen. Aus den gemessenen Werten wird zusammen mit der Pulsweite mit Hilfe einer Temperaturkompensation der aktuelle Strom ermittelt. Die Erfindung, die sich z.B. zur verlustfreien und einfachen Stromerfassung bei Gleichstrommotoren einsetzen lässt, betrifft darüber hinaus eine Schaltungsanordnung zur Durchführung des Verfahrens.

Fig. 1

## Beschreibung

Die Erfindung betrifft ein Verfahren und eine Schaltungsanordnung zur Erfassung des Stroms in einem elektrischen Gerät, das über einen mit dem Gerät gekoppelten Feldeffekttransistor (= FET) nach dem Pulsweitenmodulationsverfahren angesteuert wird. Die Erfindung eignet sich insbesondere auch zur Stromerfassung in Gleichstrommotoren, die von einem Leistungs-FET nach dem Pulsweitenmodulationsverfahren angesteuert werden.

Gleichstrommotoren werden heute in vielen Gebieten der Technik eingesetzt, so z.B. in der Kraftfahrzeugtechnik zum Antrieb eines Lüfterrades von Kühlgebläsen. Die Taktung der Versorgungsspannung des Gleichstrommotors erfolgt dabei in der Regel über einen FET, der nach dem Pulsweitenmodulationsverfahren angesteuert wird. Durch die Veränderung des dabei verwendeten Tastverhältnisses, d.h. des Verhältnisses zwischen Pulsweite und Pulspausenlänge, kann die Klemmenspannung an den Klemmen des Gleichstrommotors verändert werden, wodurch sich die Stromaufnahme des Motors und damit das Drehmoment des Antriebs verändern lässt.

Um Störungen und Beschädigungen der beschriebenen Antriebssysteme zu erkennen, wird der Motorstrom erfasst. So kann z.B. das Lüfterrad durch Laub festgeklemmt werden, was zu Überströmen und zur Erwärmung und Zerstörung elektronischer Bauteile führen kann. Ferner kann es zu einem Kurzschluss kommen, der ebenfalls zu einer Beschädigung des Antriebssystems führen kann.

Bei im Stand der Technik bekannten Ausführungen von Gebläseansteuerungen erfolgte die Erfassung des Stroms z.B. über einen Shunt-Widerstand, was jedoch den Nachteil hat, dass es zur Erzeugung von Verlustleistung kommt.

In der Patentschrift US 5, 204, 594 ist z.B. ein bürstenloser Gleichstrommotor beschrieben, bei dem zur Erfassung des Stroms ein Shunt-Widerstand in Verbindung mit einem Operationsverstärker eingesetzt wird. Auch hier kommt es zu zusätzlichen Verlusten durch den Shunt-Widerstand. Zudem ist die beschriebene Lösung kostenintensiv, da ein zusätzlicher Verstärker eingesetzt werden muss.

Die Aufgabe der vorliegenden Erfindung besteht daher darin, ein verbessertes Verfahren und eine verbesserte Schaltungsanordnung zur Erfassung des Stroms in einem elektrischen Gerät, das über einen mit dem Gerät gekoppelten Feldeffekttransistor nach dem Pulsweitenmodulationsverfahren angesteuert wird, zu schaffen, bei denen weniger Verluste auftreten und die sich auf einfache und kostengünstige Weise realisieren lassen.

Diese Aufgabe wird gelöst durch ein Verfahren zur Erfassung des Stroms in einem elektrischen Gerät, das über einen mit dem Gerät gekoppelten FET nach dem Pulsweitenmodulationsverfahren angesteuert wird, bei dem die an der Source-Drain-Strecke des FETs liegende Spannung gemessen wird, eine Temperatur in der Umgebung des FETs gemessen wird, und aus den aktuellen Werten für die Pulsweite, die Source-Drain-Spannung und die Temperatur der aktuelle Strom ermittelt wird.

Mit diesem erfindungsgemäß vorgeschlagenen Verfahren lässt sich auf einfache, kosten- und energieeffiziente Weise z.B. der Strom in Gleichstrommotoren oder anderen elektrischen Geräten erfassen, die durch einen FET nach dem Pulsweitenmodulationsverfahren angesteuert werden. Die Erfindung nutzt dabei die Tatsache aus, dass sich der FET bei der Ansteuerung wie ein ohmscher Widerstand verhält, so dass sich der Strom bestimmen lässt, wenn die Spannung und der Widerstand bekannt sind.

Die Spannung wird durch Messung der Source-Drain-Spannung des FETs ermittelt, während der Widerstand, der von der Junction-Temperatur des FETs abhängt, durch eine Temperaturkompensation ermittelt wird. Hierbei wird die Abhängigkeit der Junction-Temperatur von der Umgebungstemperatur und von den Verlusten des FETs berücksichtigt, die aus den Schalt- und Durchlassverlusten bestehen, wobei die Durchlassverluste von der aktuellen Pulsweite abhängen, die bei der Pulsweitenmodulation eingestellt ist.

Das erfindungsgemäße Verfahren kommt somit ohne einen Shunt-Widerstand aus und weist daher keine zusätzlichen Leistungsverluste auf. Darüber hinaus werden aufwendige zusätzliche Bauelemente wie Operationsverstärker vermieden.

Gemäß einer weiteren Ausführungsform, die im Anspruch 2 beschrieben ist, wird, wenn die Versorgungsspannung des elektrischen Geräts, die z.B. aus einer Batteriespannung bestehen kann, starken Schwankungen unterworfen ist, auch die aktuelle Versorgungsspannung gemessen und in die Bestimmung der Stroms einbezogen. Die aktuelle Versorgungsspannung hat einen wesentlichen Einfluss auf die Schaltverluste des FETs, die sich wiederum auf die Junction-Temperatur des FETs auswirken.

Die Aufgabe der Erfindung wird darüber hinaus durch eine Schaltungsanordnung zur Erfassung des Stroms in einem elektrischen Gerät, das über einen mit dem Gerät gekoppelten FET nach dem Pulsweitenmodulationsverfahren angesteuert wird, mit einer ersten Messeinheit, die mit dem Sourceanschluß des FETs und mit dem Drainanschluß des FETs verbunden ist und so ausgebildet ist, dass sie die über der Source-Drain-Strecke des FETs abfallende Spannung messen kann, einem Temperatursensor, der so ausgebildet ist, dass er eine Temperatur in der Umgebung des FETs messen und in ein Signal umwandeln kann und einer Steuer- und Recheneinheit gelöst, die mit der Messeinheit und dem Temperatursensor in Verbindung steht und darüber hinaus so ausgebildet ist, dass sie den FET ansteuern und aus den aktuellen Werten für die Pulsweite, die Source-Drain-Spannung und die Temperatur den aktuellen Strom ermitteln kann.

Vorteilhafte Weiterbildungen der Erfindung sind in den Unteransprüchen angegeben.

Anhand der Zeichnung wird die Erfindung nachstehend eingehend erläutert. Es zeigen

Fig. 1 ein Prinzipschaltbild einer ersten Ausführungsform einer erfindungsgemäßen Schaltungsanordnung zur Erfassung des Stroms in einem Gleichstrommotor und

Fig. 2 einen Graphen, der die Abhängigkeit des Einschaltwiderstands des bei der in der Fig. 1 dargestellten Schaltungsanordnung verwendeten FETs von der Junction-Temperatur zeigt.

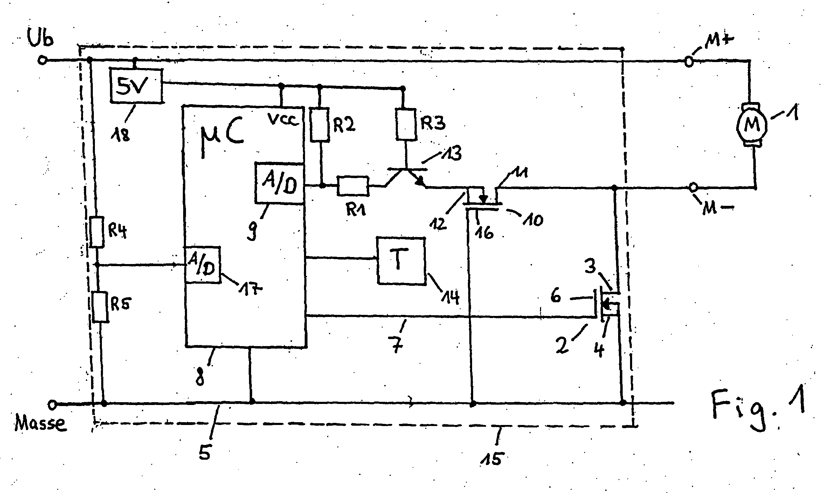

Fig. 1 zeigt ein Prinzipschaltbild einer Schaltungsanordnung zur Erfassung des Stroms in einem Gleichstrommotor. Der Gleichstrommotor soll im vorliegenden Beispiel dazu dienen, einen Lüfter anzutreiben, der in einem Kraftfahrzeug zur Kühlung eines Motors dient.

Der den (in der Fig. 1 nicht dargestellten) Lüfter antreibende Gleichstrommotor 1 ist mit einer (ebenfalls in der Fig. 1 nicht dargestellten) Fahrzeugbatterie verbunden, die eine Spannungsquelle darstellt, die eine Versorgungsspannung Ub liefert. Die Versorgungsspannung kann dabei in einem gewissen Bereich schwanken und z.B. Werte zwischen 7 und 16 Volt annehmen.

In der Fig. 1 ist darüber hinaus ein Leistungshalbleiterbauelement 2 dargestellt, das aus einem MOS-FET besteht und zur Taktung der Versorgungsspannung Ub dient. Der Drainanschluß 3 des MOS-FETs 2 ist dabei mit dem Gleichstrommotor 1 verbunden. Der Sourceanschluß 4 des MOS-FETs 2 liegt an Masse 5.

Der Gateanschluß 6 des MOS-FETs 2 ist über eine Ansteuerleitung 7 mit dem Steuerausgang eines Mikrokontrollers 8 verbunden, der Steuersignale liefert, über die der MOS-FET 2 nach dem Pulsweitenmodulationsverfahren (PWM) angesteuert wird. Soll der elektrische Lüfterantrieb z.B. nur in einem Teillastbereich betrieben werden, so wird ein PWM-Signal gewählt, dessen Pulsweite kleiner als 100 % gewählt ist. Der Mikrokontroller 8 übernimmt die Regelung der Pulsweite in Abhängigkeit vom Kühlbedarf des Motors, wobei das genaue System der Regelung hier nicht erläutert wird, da es für die Funktionsweise der vorliegenden Erfindung nicht von Bedeutung ist. Bei der in der Fig. 1 dargestellten Ausführungsform wird der Mikrokontroller 8 über einen mit der Batteriespannung Ub verbundenen Spannungsregler 18 versorgt, der eine konstante Spannung von 5 Volt liefert.

Der Mikrokontroller 8, der einen Mikroprozessor und einen Speicher umfasst, ist darüber hinaus mit Masse verbunden und umfasst einen ersten integrierten Analog/Digital-Wandler 9, an dessen Eingang die am Drainanschluß 3 des MOS-FETs 2 anliegende Spannung Udson angelegt werden kann.

Um den Eingang des Analog/Digital-Wandlers 9 vor zu hohen Spannungen während der Abschaltphase des MOS-FETs 2 zu schützen, ist eine Spannungsschutzschaltung vorgesehen, die aus dem selbstleitenden N-Kanal-MOS-FET 10 besteht. Der Drainanschluß 11 des N-Kanal-MOS-FETs 10 ist dabei mit dem Drainanschluß 3 des MOS-FETs 2 verbunden, während sein Sourceanschluß 12 über die Emitter-Kollektor-Strecke eines bipolaren Transistors 13 und den Widerstand R1 mit dem Eingang des Analog/Digital-Wandlers 9 des Mikrokontrollers 8 verbindbar ist. Der bipolare Transistor 13, dessen Basis über den Widerstand R3 mit der Batteriespannung Ub verbunden ist, ist normalerweise durchgeschaltet. Die genaue Funktion des bipolaren Transistors 13 wird in dieser Beschreibung weiter unten erläutert.

Im Folgenden wird die Funktion der Spannungsschutzschaltung erläutert. Der selbstleitende N-Kanal-MOS-FET 10 weist eine Drainstrom/Gate-Source-Spannungskennlinie auf, die der einer Triode ähnlich ist, d.h. der MOS-FET 10 sperrt ab einem gewissen negativen Wert der Gate-Source-Spannung, während er ansonsten leitend ist. Im vorliegenden Fall soll die Schwellenspannung des N-Kanal-MOS-FETs 10 zwischen 1,5 und 3 Volt liegen. Bei dem N-Kanal-MOS-FET 10 handelt es sich um einen Einzel-MOS-FET, d.h. einen nicht integrierten MOS-FET, der eine Rückwärtsdiode aufweist, die bei negativer Drain-Source-Spannung leitet.

Sobald der Leistungs-MOS-FET 2 während des Pulsweitenmodulationsverfahrens durchgeschaltet wird, ist die Spannung am Schaltungspunkt M- relativ klein und liegt unter 1 Volt. Da die Drain-Source-Spannung des N-Kanal-MOS-FETs 10 in diesem Fall negativ ist, schaltet die Rückwärtsdiode des N-Kanal-MOS-FETs 10 durch, wodurch auch die Source 12 des N-Kanal-MOS-FETs 10 spannungsmäßig heruntergezogen wird und einen Wert annimmt, der unter 1,5 Volt, d.h. unterhalb der Schwellenspannung des N-Kanal-MOS-FETs 10 liegt. Dadurch leitet der N-Kanal-MOS-FET 10 dann vollständig und die an M1-abfallende Spannung liegt dann auch am Emitter des bipolaren Transistors 13 an und kann über den Eingang des Analog/Digital-Wandlers 9 vom Mikrokontroller eingelesen und verarbeitet werden.

Wenn der Leistungs-MOS-FET 2 während des Pulsweitenmodulationsverfahrens nun wieder gesperrt wird, steigt die Spannung am Schaltungspunkt M- an, wobei sie unter Umständen die Avalanche-Spannung des MOS-FETs 2 erreichen kann. Die Rückwärtsdiode des N-Kanal-MOS-FETs 10 ist in diesem Fall gesperrt, so dass die Spannung an der Source des N-Kanal-MOS-FETs 10 ansteigt und die Schwellenspannung des N-Kanal-MOS-FETs überschreitet, woraufhin der N-Kanal-MOS-FET sperrt und der Eingang des Analog/Digital-Wandlers 9 vor der nunmehr hohen Spannung am Schaltungspunkt M1- geschützt wird. Somit erfüllt der N-Kanal-MOS-FET 10 die Funktion einer Spannungsschutzschaltung.

Wie oben bereits erwähnt wurde, ist der bipolare Transistor 13 normalerweise immer durchgeschaltet und damit für die normale Funktion der Schaltung ohne Bedeutung. Für den Fall jedoch, dass der Mikrokontroller von der Versorgungsspannung Vcc abgeschaltet wird, sperrt auch der bipolare Transistor 13 und verhindert damit sonst fließende Leckströme, falls der Schaltungspunkt M1-, z.B. über eine Motorwicklung, dauerhaft mit der Versorgungsspannung Ub verbunden ist.

Mit Hilfe der Widerstände R1 und R2 kann die eigentliche Messspannung Udson mit einem Offset versehen werden. Dadurch wird es möglich, auch negative Ströme zu messen, was für Motorsteuerungen mit Stromregelkreis von Bedeutung ist. Darüber hinaus verbessert sich das EMV-Verhalten erheblich, da Gleichrichtereffekte an Eingangsschutzdioden des Mikrokontrollers bei heftiger Einstrahlung vermieden werden.

Der Mikrokontroller 8 kann auch über den aus den Widerständen R4 und R5 gebildeten Spannungsteiler und einen zweiten Analog-Digital-Wandler 17 eine Spannung einlesen, die der Batteriespannung Ub proportional ist und so die gerade aktuelle Batteriespannung Ub messen. Es wurde bereits oben erwähnt, dass die Batteriespannung Ub gerade bei Fahrzeugbatterien in einem starken Bereich schwanken kann.

In der Fig. 1 ist darüber hinaus ein Temperatursensor 14 dargestellt, der auf der Leiterplatte 15 angebracht ist, auf der die Bauelemente und insbesondere der Leistungs-MOS-FET 2 kontaktiert sind. Bei dem Temperatursensor 14, der mit dem Mikrokontroller 8 in Verbindung steht, kann es sich z.B. um einen NTC-Fühler handeln. Der Temperatursensor 14 mißt die Temperatur am Gehäuse der Leiterplatte, wandelt den Temperaturwert in einen Spannungswert um und leitet diesen an den Mikrokontroller 8 weiter.

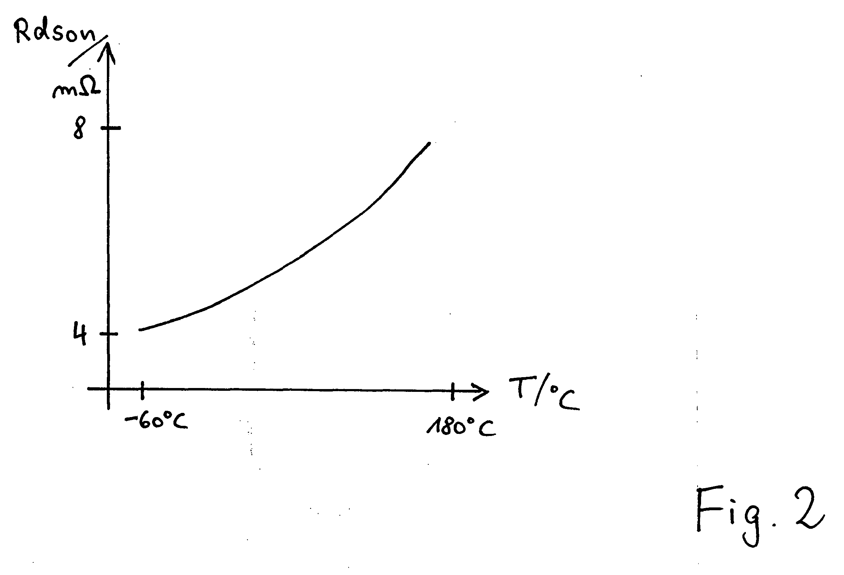

Im Folgenden wird eine Ausführungsform des erfindungsgemäßen Verfahrens zur Erfassung des Stroms in einem elektrischen Gerät anhand der Fig. 1 und 2 erläutert.

Zunächst wird in der oben beschriebenen Weise, dann, wenn der Leistungs-MOS-FET 2 sich im durchgeschalteten Zustand befindet, über den ersten Analog/Digital-Wandler 9 in dem Mikrokontroller 8 ein aktueller Wert der Drain-Source-Spannung Udson des Leistungs-MOS-FETs 2 erfaßt.

Um den Strom I zur ermitteln, der in diesem Fall durch den Leistungs-MOS-FET 2 fließt und der darüber hinaus ein Maß für den Motorstrom des Gleichstrommotors 1 darstellt, bedient man sich zunächst der folgenden ohmschen Beziehung (1), in der Rdson der Einschaltwiderstand ist:

$$I = F\ (Udson,\ Rdson) = Udson/Rdson \qquad\qquad (1)$$

Der Einschaltwiderstand Rdson des Leistungs-MOS-FETs 2 ist wiederum von der Junction-Temperatur Tfetj des Leistungs-MOS-FETs 2 abhängig, was die folgende Gleichung (2) zum Ausdruck bringt:

$$Rdson = F\ (Tfetj) \qquad\qquad (2)$$

Eine typische Abhängigkeit zwischen Rdson und Tfetj ist in der Fig. 2 dargestellt. Diese Abhängigkeit kann in Form einer Tabelle im Speicher des Mikrokontrollers 8 abgelegt sein.

Um die Abhängigkeit des Einschaltwiderstands von Tfetj zu ermitteln, muss eine Temperaturkompensation durchgeführt werden.

Dabei ist zu berücksichtigen, dass die Junction-Temperatur Tfetj wiederum abhängig ist von der durch den Temperatursensor 14 gemessenen Umgebungstemperatur Tamb, den Wärmewiderständen zwischen Junction des MOS-FETs 2 und dem Leiterplattengehäuse sowie zwischen dem Leiterplattengehäuse und der Umgebung, was durch den zusammengefassten Wärmewiderstand Rth ausgedrückt werden soll, sowie durch die Leistungsverluste des Leistungs-MOS-FETs 2, die aus den Schaltverlusten Pvsw und den Durchlassverlusten Pvon bestehen:

$$Tfetj = F\ (Tamb,\ Pvsw,\ Pvson,\ Rth) \qquad\qquad (3)$$

Die Schaltverluste Pvsw sind von der Schaltfrequenz fpwm (die im vorliegenden Fall konstant ist) des Leistungs-MOS-FETs 2, der Schaltzeit tschalt des Leistungs-MOS-FETs 2 sowie dem Spannungs- und Stromverlauf beim Ein- und Ausschalten des MOS-FETs 2 abhängig. Es lässt sich dabei eine für die vorliegenden Zwecke hinreichend genaue Funktion für die Schaltverluste entwickeln, die nur noch von den Parametern tschalt, Ub, I und fpwm abhängig ist, wobei tschalt und fpwm im vorliegenden Fall Konstanten sind:

$$Pvsw = F\ (Ub,\ I,\ tschalt,\ fpwm) \qquad\qquad (4)$$

Schließlich hängen die Durchschaltverluste Pvon von dem Einschaltwiderstand Rdson, dem gesuchten Strom I sowie der aktuell bei dem Pulsbreitenmodulationsverfahren verwendeten Pulsbreite PWM ab, was die folgende Gleichung 5 zum Ausdruck bringt:

$$Pvon = F\ (Rdson,\ I,\ PWM) \qquad\qquad (5)$$

Je größer die Pulsbreite ist, umso größer werden auch die Durchschaltverluste sein.

Mit Hilfe der Beziehungen (1), (2), (3), (4) und (5) lässt sich nun der aktuelle Strom durch den Mikrokontroller 8, in dem diese Beziehungen abgelegt sind, ermitteln. Der Mikrokontroller misst dabei zunächst den aktuellen Wert für die Batteriespannung Ub. Ferner wird der eingelesene aktuelle Wert für die Drain-Source-Spannung Udson des MOS-FETs 2 und der Wert für die aktuelle Umgebungstemperatur Tamb vom Temperatursensor 14 eingelesen. Schließlich ist dem Mikrokontroller natürlich auch die aktuelle Pulsweite PWM bekannt, da diese durch den Mikrokontroller, der auch die Ansteuerung des Leistungs-MOS-FETs 2 übernimmt, eingestellt wird. Mit Hilfe dieser aktuellen Werte für Udson, Ub, Tamb und PWM wird unter Berücksichtigung der Konstanten Rth, tschalt, fpwm durch ein rekursives Verfahren der aktuelle Strom I ermittelt.

Aus den obigen Gleichungen (5) lässt sich ein Gleichungssystem mit zwei Gleichungen bilden, die wechselseitige Abhängigkeiten zwischen Tfetj und I ausdrücken. Nun wird gemäß dem rekursiven Verfahren zunächst ein Anfangswert für die Kombination Tfetj und I probiert und es werden dann sukzessive die Werte von Tfetj und I geändert, bis die obigen Beziehungen (1) bis (5) mit hinreichender Genauigkeit aufgehen. Der so ermittelte Wert ist dann der aktuelle gesuchte Strom I.

Bei einer anderen Ausführungsform des Verfahrens, bei der nicht mit einer variablen Batteriespannung, sondern mit einer konstanten Versorgungsspannung gearbeitet wird, kann Ub als konstant angenommen werden.

Das erfindungsgemäße Verfahren kann dann so erweitert werden, dass festgestellt wird, ob der ermittelte Strom eine vorherbestimmte Stromschwelle über- und/oder unterschreitet. So kann z.B. der Mikrokontroller den ermittelten aktuellen Stromwert I mit einem vorherbestimmten und im Speicher des Mikrokontrollers 8 abgelegten kritischen Stromwert vergleichen, der nicht überschritten werden darf und z.B. auf einen Kurzschluß hinweisen kann.

Falls der kritische Stromwert überschritten wird, kann ein Signal vom Mikrokontroller erzeugt werden, woraufhin der Leistungs-FET 2 gesperrt wird.

Neben der Kurzschlussüberwachung kann das erfindungsgemäße Verfahren auch z.B. zur Stalldetektion verwendet werden, um festzustellen, ob der Lüfter z.B. unter dem Einfluß von Laub eingeklemmt ist.

Gemäß anderen Ausführungsformen der Erfindung kann der ermittelte Stromwert auch zur Stromregelung verwendet werden.

Der bei der Erfindung verwendete Temperatursensor 14 muss natürlich nicht notwendigerweise auf der Leiterplatte angebracht sein, auf der der Leistungs-FET 2 kontaktiert ist. Er muss nur in der näheren oder ferneren Umgebung des Leistungs-FET angebracht sein, so dass über bekannte Wärmewiderstände auf das Junction-Temperaturverhalten des FETs geschlossen werden kann.

Das erfindungsgemäße Verfahren sowie die erfindungsgemäße Schaltungsanordnung können natürlich nicht nur bei Gleichstrommotoren verwendet werden, sondern sind auch bei beliebigen anderen elektrischen Geräten einsetzbar, die über einen FET angesteuert werden.

**Patentansprüche**

1.  Verfahren zur Erfassung des Stroms (I) in einem elektrischen Gerät (1), das über einen mit dem Gerät (1) gekoppelten FET (2) nach dem Pulsweitenmodulationsverfahren angesteuert wird, bei dem
die an der Source-Drain-Strecke des FETs (2) liegende Spannung (Udson) gemessen wird,
eine Temperatur (Tamb) in der Umgebung des FETs (2) gemessen wird, und
aus den aktuellen Werten für die Pulsweite (PWM), die Source-Drain-Spannung (Udson) und die Temperatur (Tamb) der aktuelle Strom (I) ermittelt wird.

2. Verfahren nach Anspruch 1, bei dem darüber hinaus der aktuelle Wert der durch die Pulsweitenmodulation getakteten Versorgungsspannung (Ub) gemessen und bei der Ermittlung des Stroms (I) berücksichtigt wird.

3. Verfahren nach Anspruch 2, bei dem die Versorgungsspannung (Ub) aus einer Batteriespannung besteht.

4. Verfahren nach einem der Ansprüche 1 bis 3, bei dem darüber hinaus vor der Ermittlung des Stroms (I) die Abhängigkeit des Einschaltwiderstands des FETs von der Junction-Temperatur (Tfetj) des FETs (2) ermittelt wird.

5. Verfahren nach einem der vorhergehenden Ansprüche, bei dem zur Ermittlung des Stroms (I) Beziehungen zwischen dem zu ermittelnden Strom (I) und der Junction-Temperatur (Tfetj) des FETs (2) verwendet werden.

6. Verfahren nach Anspruch 5, bei dem die Beziehungen aus
der Abhängigkeit des Stroms (I) von der Source-Drain-Spannung (Udson) und dem Einschaltwiderstand (Rdson) des FETs (2),
der Abhängigkeit des Einschaltwiderstands (Rdson) von der Junction-Temperatur (Tfetj) des FETs (2),
der Abhängigkeit der Junction-Temperatur (Tfetj) des FETs (2) von der Umgebungstemperatur (Tamb), den Durchlassverlusten (Pvon) des FETs (2), den Schaltverlusten (Pvsw) des FETs (2),
der Abhängigkeit der Durchlassverluste (Pvon) von dem Einschaltwiderstand (Rdson) des FETs (2), dem Strom (I) sowie der Pulsweite (PWM) und
der Abhängigkeit der Schaltverluste (Pvsw) von der Versorgungsspannung (Ub) und dem Strom (I) bestehen.

7. Verfahren nach Anspruch 6, bei dem darüber hinaus eine konstante Schaltfrequenz (fpwm) des FETs in die Berechnung der Schaltverluste (Pvsw) einbezogen wird.

8. Verfahren nach einem der Ansprüche 6 oder 7, bei dem darüber hinaus eine vorher bestimmte Schaltzeit (tschalt) des FETs (2) in die Berechnung der Schaltverluste (Pvsw) einbezogen wird.

9. Verfahren nach einem der Ansprüche 6 bis 8, bei dem darüber hinaus ein vorherbestimmter Wärmewiderstand (Rth) für den Übergang FET-Junction/Umgebung in die Berechnung der Durchlassverluste (Pvon) einbezogen wird.

10. Verfahren nach einem der Ansprüche 5 bis 9, bei dem die Ermittlung des Stroms (I) mit Hilfe eines rekursiven Verfahrens durchgeführt wird.

11. Verfahren nach Anspruch 10, bei dem das rekursive Verfahren so durchgeführt wird, dass Anfangswerte für den zu ermittelnden Strom (I) und die Junction-Temperatur (Tfetj) des FETs (2) bestimmt und dann solange verändert werden, bis die Werte sich den Beziehungen mit hinreichender Genauigkeit anpassen.

12. Verfahren nach einem der vorhergehenden Ansprüche, das darüber hinaus den Schritt umfasst, festzustellen, ob der ermittelte Strom (I) eine vorherbestimmte Stromschwelle über- und/oder unterschreitet.

13. Verfahren nach Anspruch 12, bei dem darüber hinaus der FET (2) gesperrt wird, wenn der ermittelte Strom (I) eine vorherbestimmte Stromschwelle über- oder unterschreitet.

14. Verfahren nach einem der vorhergehenden Ansprüche, bei dem der FET (2) ein Leistungs-FET ist.

15. Verfahren nach einem der vorhergehenden Ansprüche, bei dem der FET (2) ein MOS-FET ist.

16. Verfahren nach einem der vorhergehenden Ansprüche, bei dem das elektrische Gerät ein Gleichstrommotor (1) ist.

17. Verfahren nach Anspruch 16, bei dem der Gleichstrommotor (1) bürstenlos ist.

18. Verfahren nach Anspruch 13, das zur Stallprotection verwendet wird.

19. Verfahren nach Anspruch 13, das zur Kurzschlußüberwachung verwendet wird.

20. Verfahren nach einem der vorhergehenden Ansprüche, bei dem der ermittelte Strom (I) zur Stromregelung verwendet wird.

21. Verfahren nach einem der vorhergehenden Ansprüche, bei dem die Messung der Temperatur (Tamb) in der Umgebung des FETs (2) so durchgeführt wird, dass ein Temperatursensor (14) auf der Leiterplatte (15) angebracht ist, auf der der FET (2) kontaktiert ist.

22. Verfahren nach Anspruch 21, bei dem der Temperatursensor (14) aus einem NTC-Fühler besteht.

23. Schaltungsanordnung zur Erfassung des Stroms (I) in einem elektrischen Gerät (1), das über einen mit dem Gerät (1) gekoppelten FET (2) nach dem Pulsweitenmodulationsverfahren angesteuert wird, mit
einer ersten Messeinheit, die mit dem Sourceanschluß (4) des FETs (2) und mit dem Drainanschluß (3) des FETs (2) verbunden ist und so ausgebildet ist, dass sie die über der Source-Drain-Strecke des FETs (2) abfallende Spannung (Udson) messen kann,
einem Temperatursensor (14), der so ausgebildet ist, dass er eine Temperatur (Tamb) in der Umgebung des FETs (2) messen und in ein Signal umwandeln kann und
einer Steuer- und Recheneinheit (8), die mit der Messeinheit und dem Temperatursensor (14) in Verbindung steht und darüber hinaus so ausgebildet ist, dass sie den FET (2) ansteuern und aus den aktuellen Werten für die Pulsweite (PWM), die Source-Drain-Spannung (Udson) und die Temperatur (Tamb) den aktuellen Strom (I) ermitteln kann.

24. Schaltungsanordnung nach Anspruch 23, die darüber hinaus eine zweite Messeinheit umfasst, die so ausgebildet ist, dass sie eine an dem elektrischen Gerät (1) anliegende Versorgungsspannung (Ub) messen kann, wobei die Steuer- und Recheneinheit mit der zweiten Messeinheit in Verbindung steht und die aktuelle Versorgungsspannung (Ub) bei der Ermittlung des aktuellen Stroms (I) berücksichtigt.

25. Schaltungsanordnung nach einem der Ansprüche 23 oder 24, bei der die Steuer- und Recheneinheit darüber hinaus einen Speicher umfasst, in dem eine vorher ermittelte Tabelle abgelegt ist, in der Daten enthalten sind, die die Abhängigkeit des Einschaltwiderstands des FETs von der Junction-Temperatur des FETs repräsentieren.

26. Schaltungsanordnung nach Anspruch 25, bei der die Steuer- und Recheneinheit darüber hinaus so ausgebildet ist, dass sie Beziehungen zwischen dem zu ermittelnden Strom und der Junction-Temperatur des FETs verwendet, um den aktuellen Strom zu ermitteln.

27. Schaltungsanordnung nach Anspruch 26, bei der die Beziehungen aus
der Abhängigkeit des Stroms von der Source-Drain-Spannung und dem Einschaltwiderstand des FETs,
der Abhängigkeit des Einschaltwiderstands von der Junction-Temperatur des FETs,
der Abhängigkeit der Junction-Temperatur des FETs von der Umgebungstemperatur, den Durchlassverlusten des FETs, den Schaltverlusten des FETs,
der Abhängigkeit der Durchlassverluste von dem Einschaltwiderstand des FETs, dem Strom sowie der Pulsweite und
der Abhängigkeit der Schaltverluste von der Versorgungsspannung und dem Strom bestehen.

28. Schaltungsanordnung nach Anspruch 27, bei der die Steuer- und Recheneinheit darüber hinaus so ausgebildet ist, dass sie eine konstante Schaltfrequenz des FETs in die Berechnung der Schaltverluste einbeziehen kann.

29. Schaltungsanordnung nach Anspruch 27 oder 28, bei der die Steuer- und Recheneinheit darüber hinaus so ausgebildet ist, dass sie eine vorher bestimmte Schaltzeit des FETs in die Berechnung der Schaltverluste einbeziehen kann.

30. Schaltungsanordnung nach einem der Ansprüche 27 bis 29, bei der die Steuer- und Recheneinheit darüber hinaus so ausgebildet ist, dass sie einen vorherbestimmten Wärmewiderstand für den Übergang FET-Junction/Umgebung in die Berechnung der Durchlassverluste einbeziehen kann.

31. Schaltungsanordnung nach einem der Ansprüche 27 bis 30, bei dem die Steuer- und Recheneinheit darüber hinaus so ausgebildet ist, dass sie die Ermittlung des Stroms mit Hilfe eines rekursiven Verfahrens durchführen kann.

32. Schaltungsanordnung nach Anspruch 31, bei dem die Steuer- und Recheneinheit darüber hinaus so ausgebildet ist, dass sie das rekursive Verfahren so durchführen kann, dass Anfangswerte für den zu ermittelnden Strom und die Junction-Temperatur des FETs bestimmt und dann solange verändert werden, bis die Werte sich den Beziehungen mit hinreichender Genauigkeit anpassen.

**33.** Schaltungsanordnung nach einem der Ansprüche 23 bis 32, bei der der FET ein Leistungs-FET ist.

**34.** Schaltungsanordnung nach einem der Ansprüche 23 bis 33, bei der der FET ein MOS-FET ist.

**35.** Schaltungsanordnung nach einem der Ansprüche 23 bis 34, bei der das elektrische Gerät ein Gleichstrommotor ist.

**36.** Schaltungsanordnung nach Anspruch 35, bei der der Gleichstrommotor bürstenlos ist.

**37.** Schaltungsanordnung nach einem der Ansprüche 23 bis 36, bei der der Temperatursensor (14) auf der Leiterplatte (15) angebracht ist, auf der der FET (2) kontaktiert ist.

**38.** Schaltungsanordnung nach Anspruch 37, bei der der Temperatursensor ein NTC-Fühler ist.

**39.** Schaltungsanordnung nach einem der Ansprüche 24 bis 38, bei der die erste Messeinheit, die zweite Messeinheit und die Steuer- und Recheneinheit in einen Mikrokontroller integriert sind, der einen Prozessor und einen Speicher aufweist.

**40.** Schaltungsanordnung nach Anspruch 39, bei der der Mikrokontroller einen Analog-Digital-Wandler (9) aufweist, an dessen Eingang die zu messende Spannung, die an der Source-Drain-Strecke des FETs (2) abfällt, anliegt.

**41.** Schaltungsanordnung nach Anspruch 40, bei der eine Spannungsschutzschaltung vorgesehen ist, die den Eingang des Analog-Digital-Wandlers (9) vor kritischen Spannungen schützt.

**42.** Schaltungsanordnung nach Anspruch 41, bei der die Spannungsschutzschaltung aus einem selbstleitenden N-Kanal-Einzel-MOS-FET (10) mit Rückwärtsdiode besteht.

**43.** Schaltungsanordnung nach Anspruch 42, bei der der Sourceanschluß (12) des N-Kanal-MOS-FETs (10) mit dem Eingang des Analog-Digital-Wandlers (9) gekoppelt ist, während sein Drainanschluß (11) mit dem Drainanschluß (3) des FETs (2) und sein Gateanschluß mit Masse (5) gekoppelt ist.

**44.** Gleichstrommotor mit einer Ansteuerungsschaltung, die eine Schaltungsanordnung nach einem Ansprüche 23 bis 43 umfaßt.

Fig. 1

Ub

Masse

5V  18

MC

Vcc

A/D  9

R2

R3

R1

13

A/D  17

R4

R5

T  14

11

12  16  10

M+

M  1

M—

3

6

2  4

5

7

15

8

EP 1 626 488 A2

9

Fig. 2

EP 1 626 488 A2